# EUROPÄISCHE PATENTSCHRIFT

(11) **EP 2 090 147 B1**
(45) Veröffentlichungstag und Bekanntmachung des Hinweises auf die Patenterteilung: **11.01.2012**
(21) Anmeldenummer: 07821332.9
(22) Anmeldetag: 15.10.2007
(51) Int. Cl.: H05K 10/00, F16D 66/00, F16D 66/02

(54) **ELEKTRONISCHES GERÄT**
ELECTRONIC DEVICE
APPAREIL ÉLECTRONIQUE

(30) Priorität: 10.11.2006 DE 102006053398
(43) Veröffentlichungstag der Anmeldung: 19.08.2009
(73) Patentinhaber: Endress+Hauser GmbH+Co. KG, 79689 Maulburg (DE)
(72) Erfinder: HAMMER, Manfred, 79664 Wehr (DE); SCHROTH, Herbert, 79650 Schopfheim (DE); SPANKE, Dietmar, 79585 Steinen (DE)
(74) Vertreter: Andres, Angelika Maria
(86) Internationale Anmeldenummer: PCT/EP2007/060965
(87) Internationale Veröffentlichungsnummer: WO 2008/055759

(56) Entgegenhaltungen:
- DE-B1- 2 910 587
- US-A- 5 668 529

## Beschreibung

Die Erfindung betrifft ein elektronisches Gerät mit einer in einem Elektronikraum angeordneten, elektronische und/oder elektromechanische Komponenten aufweisenden Elektronik.

In der der Mess- und Regeltechnik sind heute eine Vielzahl elektronischer Geräte im Einsatz. Insb. werden zur Kontrolle, Steuerung und/oder Automatisierung komplexer Prozesse Messgeräte, wie z.B. Druck-,

Temperatur-, Durchfluss- und/oder Füllstandsmessgeräte, eingesetzt. Diese elektronischen Geräte weisen regelmäßig eine oder mehrere in einem Elektronikraum angeordnete Elektroniken auf, die eine VielzaH verschiedener elektronischer und /oder elektromechanischer Komponenten aufweisen.

In industriellen Anwendungen sind diese elektronischen Geräte häufig sehr rauen Umgebungsbedingungen ausgesetzt. Es besteht daher z.B. die Gefahr, dass aggressive Medien, insb. Säuren oder Lösungsmittel, in den Elektronikraum eindringen und wichtige elektronische und/oder elektromechanische Komponenten beschädigen oder gar zerstören können. Weitere mögliche Ursachen für eine Abnutzung sind Stöße, Vibration, extreme Temperaturen, oder beispielsweise ionisierende StraHung.

Die Elektroniken sind in der Regel in fest verschlossenen Gehäusen angeordnet und durch Vergussmassen geschützt, so dass sie von außen nicht ohne weiteres zugänglich sind. Entsprechend kann eine Abnutzung der elektronischen und/oder elektromechanischen Komponenten, wie sie z.B. durch das Eindringen aggressiver Medien in den Elektronikraum verursacht werden, kann von außen erst dann erkannt werden, wenn es zu einer Fehlfunktion oder zu einem Totalausfall der Elektronik kommt. Hiermit ist ein großes Sicherheitsrisiko verbunden, das in der Regel nur durch regelmäßige Wartungen und/oder einen frühzeitigen Austausch der elektronischen Geräte vermieden werden kann.
DE-BI-2910587 gaschreigt ein elektrisches gerät mit einer überwachungsenheit und Auzeigermitteln 3^{eme} Anzeigen von störungen der funktion der in dem gerät enthaltenen Einzätze.

Es ist eine Aufgabe der Erfindung, ein elektronisches Gerät anzugeben,

das selbsttätig eine Abnutzung seiner elektronischen und/oder elektromechanischen Komponenten erkennt und/oder überwacht.

Hierzu besteht die Erfindung in einem elektronisches Gerät mit

- einer in einem Elektronikraum angeordneten, elektronische und/oder

elektromechanische Komponenten aufweisenden Elektronik und

- einer Vorrichtung zur Erkennung und/oder Überwachung einer

Abnutzung der elektronischen und/oder elektromechanischen Komponenten

-- die mindestens ein im Elektronikraum angeordnetes von der

Elektronik unabhängiges Bauteil aufweist,

--- das mindestens eine physikalische Eigenschaft aufweist, die sich in Abhängigkeit von der Abnutzung des Bauteils irreversibel

verändert,

-- die eine Schaltung zur Messung dieser physikalischen Eigenschaft

aufweist, und

-- die eine Auswerteinheit aufweist,

--- die anhand der gemessenen physikalischen Eigenschaft eine

Abnutzung des Bauteils erkennt und/oder überwacht und ein von der

Abnutzung abhängiges Ausgangssignal zur Verfügung stellt.

Gemäß einer bevorzugten Ausgestaltung ist das Bauteil an exponierter Stele angeordnet.

Gemäß einer Weiterbildung umfasst das Bauteil einen Kunststoffblock, der zumindest teilweise von einem Überzug aus einem unedlen Metall umgeben ist.

Gemäß einer ersten Ausgestaltung ist das Bauteil ein diskret aufgebauter Kondensator, und die Eigenschaft ist eine Kapazität des Kondensators.

Gemäß einer zweiten Ausgestaltung ist das Bauteil ein Widerstand.

Ein Vorteil der Erfindung besteht darin, dass die Vorrichtung ein von der Abnutzung abhängiges Ausgangsignal zur Verfügung stellt. Damit ist für den Betreiber von außen erkennbar, ob eine Abnutzung vorliegt oder nicht. Hierdurch ist es für den Betreiber möglich, Wartungsintervale und/oder Austauschintervalle zu optimieren. Somit können unnötige Wartungen und/oder Austäusche von Geräten ohne Sicherheitseinbußen vermieden werden.

Die Erfindung und weitere Vorteile werden nun anhand der Figuren der Zeichnung, in denen zwei Ausführungsbeispiele dargestellt sind, näher erläutert. Gleiche Elemente sind in den Figuren mit denselben Bezugszeichen versehen.
Fig. 1 zeigt eine teilweise geschnittene Ansicht eines erfindungsgemäßen elektronischen Geräts;
Fig. 2 zeigt eine Leiterplatte mit der Elektronik und der Vorrichtung zur Ermittlung und/oder Überwachung einer Abnutzung der Komponenten
   der Elektronik;
Fig. 3 zeigt einen auf der Leiteplatte angeordneten Widerstand; und
Fig. 4 zeigt einen auf der Leiteplatte angeordneten Kondensator.

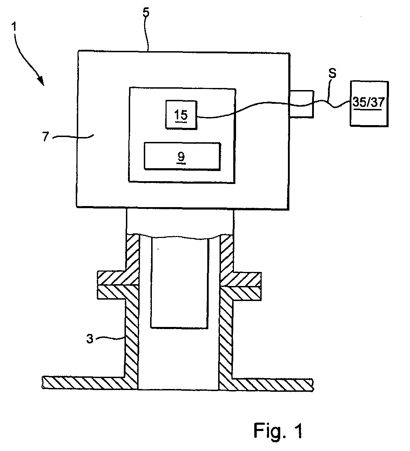

Fig. 1 zeigt eine teilweise geschnittene Ansicht eines elektronischen Geräts 1. In dem dargestellten Ausführungsbeispiel ist das elektronische Gerät 1 ein Messgerät, z.B. ein Sensor, ein Messaufnehmer oder ein Transmitter, das auf einem Montagestutzen 3 an einem Messort, z.B. auf einem Behälter, montiert ist. Derartige Geräte werden in einer Vielzahl von Anwendungen in der Mess- und Regeltechnik, z.B. zur Messung von Drücken, Temperaturen oder Füllständen, eingesetzt. Die Erfindung ist aber auch in Verbindung mit anderen Arten von elektronischen Geräten einsetzbar, die eine in einem Elektronikraum angeordnete Elektronik aufweisen.

Das Gerät 1 weist ein Gehäuse 5 auf. Im Gehäuse 5 befindet sich der Elektronikraum 7, in dem eine Elektronik 9 angeordnet ist.

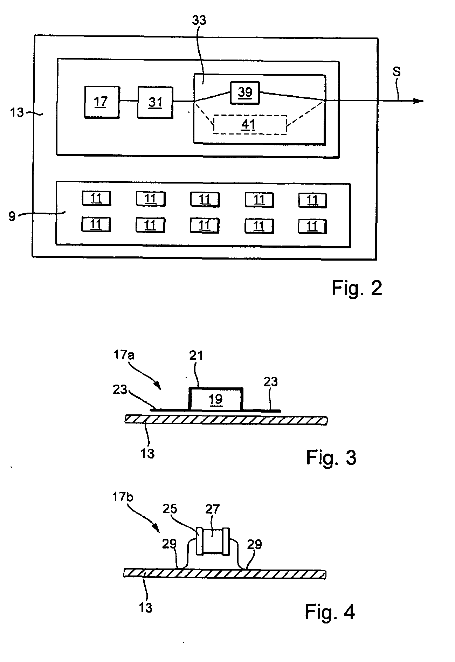

Die Elektronik 9 umfasst eine Vielzahl elektronischer und/oder elektromechanischer Komponenten 11, die beispielsweise, wie in Fig. 2 dargestellt, auf einer Leiterplatte 13 angeordnet sind. Beispiele elektronischer Komponenten sind passive Bauelemente wie Widerstände, Kondensatoren, Schwingquartze und dergleichen sowie aktive Bauelemente wie Transistoren, Microcontrdler, Speicherbausteine, Flüssigkristallanzeigen und ähnliches. Beispiele elektromechanischer Komponenten sind Steckverbinder, Verbindungskabel, Relais, Schalter, etc.

Erfindungsgemäß umfasst das elektronische Gerät 1 eine Vorrichtung 15 zur Erkennung und/oder Überwachung einer Abnutzung der elektronischen und/oder elektromechanischen Komponenten 11. Eine Abnutzung der elektronischen und/oder elektromechanischen Komponenten 11 kann z.B. durch in den Elektronikraum 7 eindringende aggressive Medien, wie z.B. Säuren oder Lösungsmittel, verursacht werden. Diese Medien greifen die elektronischen und/oder elektromechanischen Komponenten 11 an. Dies führt zu einer Abnutzung der elektronischen und/oder elektromechanischen Komponenten 11, und kann zu einer Beeinträchtigung der Funktionalität der Komponenten 11 führen. Andere mögliche Ursache für eine Abnutzung sind beispielsweise hohe Temperaturen, die zu einer vorzeitigen Alterung der Komponenten 11 führen können, schnelle Temperaturschwankungen, die zu Spannungsbrüchen führen können, oder ionisierende Strahlen, die Kunststoffe verspröden lassen oder Halbleiterbauelemente beschädigen können, sowie Vibration und Schock, die zu Brüchen durch Materialermüdung führen können. Die Vorrichtung 15 dient dazu, eine dadurch hervorgerufene Abnutzung zu erkennen und/oder zu überwachen, ohne dass hierzu das elektronische Gerät 1 geöffnet werden muss.

Die Vorrichtung 15 umfasst mindestens ein im Elektronikraum 7 angeordnetes Bauteil 17. Das Bauteil 17 ist vorzugsweise an exponierter Stelle im Elektronikraum 7 angeordnet, so dass gegebenenfalls in den Elektronikraum 7 eindringende aggressive Medien bzw. die Umgebungstemperatur, ionisierende Strahlen, mechanische Belastungen usw. unmittelbar auf das Bauteil 17 einwirken. Als exponierte Stellen eignen sich zum Beispiel Orte im Gehäuse 5, die nicht durch weitere Schutzmaßnahmen, wie z.B. Abdeckungen, oder Vergussmassen geschützt sind. Ebenso eignen sich Orte, an denen die Gefahr eindringenden Mediums besonders hoch ist, z.B. in der Nähe von Durchführungen durch das Gehäuse 5 oder im Bereich von Abdichtungen, z.B. zwischen aneinander angrenzenden Teilen des Gehäuses 5. Das Bauteil 17 weist mindestens eine physikalische Eigenschaft auf, die sich in Abhängigkeit von der Abnutzung des Bauteils 17 irreversibel verändert. Als Bauteile 17 eignen sich z.B. diskret aufgebaute Widerstände oder Kondensatoren. Es können hierzu z.B. handelsübliche Standardbauteile eingesetzt werden. Die physikalischen Eigenschaften sind dabei abhängig von der Wahl des Bauteils 17. Als Beispiele seien hier ein von der Abnutzung abhängiger Widerstandswert eines Widerstandes, oder eine von der Abnutzung abhängige Kapazität eines Kondensators genannt.

Es können aber auch andere Bauteilarten mit anderen von deren Abnutzung abhängigen elektrischen, thermischen, chemischen, optischen, oder mechanischen Eigenschaften in Verbindung mit der Erfindung eingesetzt werden, wie z.B. der Wärmeübergangswiderstand eines beschichteten Bauteils zur Umgebung, wenn sich die Beschichtung ablöst, das optische Absorptions vermögen einer Substanz, die sich durch chemische Reaktion verändert, oder der Elastizitätsmodul eines elektromechanischen Schwingers, der durch ionisierende Strahlung an Elastizität verliert.

Auf diese Weise kann nicht nur die Abnutzung von Bauteilen durch langfristige Einwirkung schädlicher Bedingungen überprüft werden, sondern auch die Abnutzung durch das Auftreten von kurzfristigen Extremzuständen, indem beispielsweise im Bauteil 17 ein Bruch eines Leiters durch mechanische oder thermische Überbeanspruchung zur Erkennung und/oder Überwachung der Abnutzung des elektronischen Geräts 1 herangezogen wird.

Da bei der vorliegenden Erfindung eine irreversible Veränderung einer physikalische Eigenschaft des Bauteils 17 ausgenutzt wird, die sich unabhängig vom Betriebszustand des elektronischen Geräts 1 ändert, werden nicht nur Abnutzungen erkannt, die während des Betriebs auftreten, sondern auch sdche die während eines Transports, durch eine Lagerung, oder während Stillstandszeiten eingetreten sind.

Fig. 3 zeigt ein erstes bevorzugtes Ausführungsbeispiel eines Bauteil 17a. Es umfasst einen Widerstand, der einen Kunststoffblock 19, z.B. aus Pdyethylen oder aus Polystyrol, aufweist. Vorzugsweise wird ein sehr einfacher Kunststoff verwendet, der nicht lösungsmittelbeständig ist. Der Block 19 ist zumindest teilweise von einem Überzug 21 aus einem unedlen Metall 21, z.B. Aluminium, umgeben. Als physikalische Eigenschaft dieses Bauteils 17 dient dessen Widerstand R. Dieser wird beispiekweise über zwei zu beiden Seiten endseitig am Überzug 21 angeordnete Anschlüsse 23 abgegriffen.

Ein besonderer Vorteil dieses Bauteils 17a besteht darin, dass sich der Widerstand R sowohl in Abhängigkeit von einer Abnutzung des Kunststoffblocks 19 als auch in Abhängigkeit von einer Abnutzung des metallischen Überzugs 21 verändert. Auf diese Weise können mit einem einzigen Bauteil 17a sowohl Abnutzungen durch eindringende Lösungsmittel, die den Kunststoff angreifen, als auch durch eindringende Säuren, die das Metall angreifen, entdeckt und/oder überwacht werden.

Fig. 4 zeigt ein zweites bevorzugtes Ausführungsbeispiel eines Bauteil 17b. Es umfasst einen diskret aufgebauten Kondensator. In dem Beispiel ist ein Plattenkondensator mit zwei einander gegenüberliegenden metallischen Kondensatorplatten 25 und einem dazwischen angeordneten Dielektrikum 27 dargestellt. Andere Formen und Geometrien sind selbstverständlich ebenfalls einsetzbar. Als physikalische Eigenschaft dieses Bauteils 17b dient dessen Kapazität C, die beispielsweise über zwei an die jeweiligen Kondensatorplatten 25 angeschlossenen AnscHüsse 29 abgegriffen wird.

Auch bei diesem Bauteil 17b besteht der besondere Vorteil, dass sich die physikalische Eigenschaft des Bauteils 17b, hier dessen Kapazität C, sowohl in Abhängigkeit von einer Abnutzung des Dielektrikums 27, als auch in Abhängigkeit von einer Abnutzung der metallischen Kondensatorplatten 25 verändert. Auf diese Weise können mit einem einzigen Bauteil 17a sowohl Abnutzungen durch eindringende Lösungsmittel, die das Dielektrikum angreifen, als auch durch eindringende Säuren, die das Metall angreifen, entdeckt und/oder überwacht werden.

Neben der zuvor genannten Abnutzung durch Lösungsmittel und Säuren können durch entsprechende Bauteile 17 auch andere Formen der Abnutzung erkannt und/oder überwacht werden. So kann beispielsweise zur Erkennung und/oder Überwachung einer Abnutzung durch eindringende ionisierende Strahlung ein Halbleiters als Bauteil 17 eingesetzt werden, dessen Leitfähigkeit sich durch darauf einwirkende ionisierende Strahlung verändert oder ein Feldeffekttransistor, bei dem sich der Isolationswiderstand zwischen Gate und Source ändert.

Eine Abnutzung durch Alterung lässt sich beispielsweise erkennen und/oder überwachen, in dem ein Kondensator mit einem Elektrdyt eingesetzt wird, der mit der Zeit austrocknet. Die dadurch bedingte Veränderung der Kapazität dieses Kondensators ist ein Maß für die Lebensdauer der elektronischen Komponenten 11.

Bei Anwendungen, bei denen es viele verschiedene Ursachen für eine Abnutzung gibt können natürlich mehrere Vorrichtungen 15 eingesetzt werden, oder es können unterschiedliche Bauteile 17 miteinander kombiniert werden, indem sie beispielsweise parallel oder in Serie geschaltet werden, und eine oder mehrere physikalische Eigenschaften der aus den Bauteilen 17 aufgebauten Schaltung herangezogen werden.

Die Vorrichtung 15 zur Erkennung und/oder Überwachung der Abnutzung umfasst eine Schaltung 31 zur Messung der physikalischen Eigenschaft des jeweiligen Bauteils 17. In Verbindung mit dem in Fig. 3 dargestellten Bauteil 17a ist dies eine an die Anschlüsse 23 angeschlossene Widerstandsmessschaltung. In Verbindung mit dem in Fig. 4 dargestellten Bauteil 17b ist dies eine an die Anschlüsse 29 angeschlossene Kapazitätsmessschaltung. Derartige Schaltungen sind hinlänglich bekannt und daher hier nicht näher erläutert.

Weiter umfasst die Vorrichtung 15 eine Auswerteinheit 33, die anhand der gemessenen physikalischen Eigenschaft eine Abnutzung des Bauteils erkennt und/oder überwacht und ein von der Abnutzung abhängiges Ausgangssignal S zur Verfügung stellt.

Das Ausgangssignal S kann unmittelbar einer Anzeige 35 oder einer übergeordneten Einheit 37, z.B. einer Warte, zugeführt werden. Das Ausgangsignals S ist damit von außen für den Betreiber zugänglich, ohne dass es einer Öffnung des elektrischen Geräts 1 bedarf. Hierdurch ist es auf sehr einfache und kostengünstige Weise möglich Wartungsintervalle zu optimieren, ohne dass hierdurch Sicherheitseinbußen auftreten.

Zur Erkennung einer Abnutzung genügt es, wenn die Auswerteeinheit 33 einen einfachen Komparator 39 aufweist, der die gemessene physikalische Eigenschaft mit einem vorgegebenen Referenzwert vergleicht. Der Referenzwert wird anhand eines Ausgangswertes der physikalischen Eigenschaft bestimmt, die das Bauteil 17 vor dem Einsatz aufweist. Liegt beispielsweise der gemessene Widerstand R des in Fig. 3 dargestellten Bauteils 17a unterhalb des vorgegebenen Referenzwert, so liegt keine Abnutzung vor. Übersteigt er den Referenzwert, so liegt eine Abnutzung vor. Dies gilt analog für das in Fig. 4 dargestellte Ausführungsbeispiel. Liegt die gemessene Kapazität des in Fig. 4 dargestellten Bauteils 17b oberhalb eines vorgegebenen Referenzwert, so liegt keine Abnutzung vor. Sinkt sie unter den Referenzwert, so liegt eine Abnutzung vor. Das Ausgangssignal des Komparators 39 kann unmittelbar als Ausgangssignal S verwendet werden.

Ist darüber hinaus eine Überwachung der Abnutzung gewünscht, so umfasst die Auswerteeinheit 33 vorzugsweise eine Signalverarbeitung 41, z. B. einen Mikrokontroller, die einen zeitlichen Verlauf der gemessenen physikalischen Eigenschaften ermittelt. Diese Variante ist in Fig. 2 durch eine gestrichelte Linienführung dargestellt. Dort werden beispielsweise die gemessenen physikalischen Eigenschaften zusammen mit dem Zeitpunkt, zu dem sie gemessen wurden, über einen Zeitraum abgespeichert. Auch hier wird vorzugsweise der bereits in Verbindung mit der Erkennung der Abnutzung beschriebene Referenzwert eingesetzt. Vorzugsweise wird anhand des zeitlichen Verlaufs der physikalischen Eigenschaften beispielsweise durch Extrapdation errechnet, wann mit einem Unter- bzw. Überschreiben des Referenzwertes zu rechnen ist. Als Ausgangssignal S wird hier beispielsweise ein Signal verwendet, dass die verbleibende Zeit bis zu der zu erwartenden Abnutzung wiedergibt. Dieses Ausgangssignal S ist von außen zugänglich und erlaubt dem Betreiber eine längerfristige Planung seiner Wartungsintervalle, bzw. eines gegebenenfalls erforderlichen Austauschs des Geräts 1.

Ein Vorteil der Erfindung besteht darin, dass das Gerät 1 selbsttätig erkennt, ob eine Abnutzung vorliegt. Auf diese Weise können Wartung und/oder Austausch der Geräte 1 optimiert werden. Unnötige Wartungen und Austäusche entfallen.

**Tabelle 1**

| Zeichen | Bezeichnung |
|---|---|
| 1 | elektronisches Gerät |
| 3 | Montagestutzen |
| 5 | Gehäuse |
| 7 | Elektronikraum |
| 9 | Elektronik |
| 11 | elektronische und/oder elektromechanische Komponenten |
| 13 | Leiterplatte |
| 15 | Vorrichtung |
| 17 | Bauteil |
| 17a, 17b | Bauteil |
| 19 | Kunststoffblock |
| 21 | Überzug |
| 23 | Anschlüsse |
| 25 | Kondensatorplatten |
| 27 | Dielektrikum |
| 29 | Anschlüsse |
| 31 | Schaltung zur Messung der physikalischen Eigenschaft |
| 33 | Auswerteeinheit |
| 35 | Anzeige |
| 37 | übergeordnete Einheit |
| 39 | Komparator |
| 41 | Signalverarbeitung |

## Patentansprüche

1. Elektronisches Gerät (1) mit
- einer in einem Elektronikraum (7) angeordneten, elektronische und/oder elektromechanische Komponenten (11) aufweisenden Elektronik (9) und
- einer Vorrichtung (15) zur Erkennung und/oder Überwachung einer Abnutzung der elektronischen und/oder elektromechanischen Komponenten (11),
-- die mindestens ein im Elektronikraum (7) angeordnetes von der Elektronik (9) unabhängiges Bauteil (17, 17a, 17b) aufweist,
-- das mindestens eine physikalische Eigenschaft aufweist, die sich in Abhängigkeit von der Abnutzung des Bauteils (17, 17a, 17b) irreversibel verändert,
- die eine Schaltung (31) zur Messung dieser physikalischen Eigenschaft aufweist, und
-- die eine Auswerteinheit (33) aufweist,
--- die anhand der gemessenen physikalischen Eigenschaft eine Abnutzung des Bauteils (17, 17a, 17b) erkennt und/oder überwacht und ein von der Abnutzung abhängiges Ausgangssignal (S) zur Verfügung stellt.

2. Elektronisches Gerät (1) nach Anspruch 1, bei der das Bauteil (17, 17a, 17b) an exponierter Stelle angeordnet ist.

3. Elektronisches Gerät (1) nach Anspruch 1, bei der das Bauteil (17a) einen Kunststoffblock (19) umfasst, der zumindest teilweise von einem Überzug (21) aus einem unedlen Metall umgeben ist.

4. Elektronisches Gerät (1) nach Anspruch 1, bei der das Bauteil (17b) ein diskret aufgebauter Kondensator ist, und die Eigenschaft eine Kapazität des Kondensators ist.

5. Elektronisches Gerät (1) nach Anspruch 1, bei der das Bauteil ein Widerstand (17a) ist.

## Claims

1. Electronic device (1) with
- an electronics system (9) which is arranged in an electronics compartment (7) and has electronic and/or electromechanical components
- a unit (15) designed to detect and/or monitor wear and tear of the electronic and/or electromechanical components (11),
-- which has at least one component (17, 17a, 17b) which is independent of the electronics system (9) and is arranged in the electronics compartment (7),
-- which has at least one physical property which changes irreversibly depending on the how worn out the component (17, 17a, 17b) is,
-- which has a circuit (31) designed to measure this physical property, and
-- which has an evaluation unit (33),
--- which, on the basis of the physical property measured, detects and/or monitors wear and tear of the component (17, 17a, 17b) and which delivers an output signal (S) which depends on how much the component is worn.

2. Electronic device (1) as claimed in Claim 1, where the component (17, 17a, 17b) is arranged at an exposed point.

3. Electronic device (1) as claimed in Claim 1, where the component (17a) comprises a plastic block (19) which is at least partially surrounded by a coating (21) made from a base metal.

4. Electronic device (1) as claimed in Claim 1, where the component (17b) is a discretely designed capacitor and the property is a capacitance of the capacitor.

5. Electronic device (1) as claimed in Claim 1, where the component is a resistor (17a).

## Revendications

1. Appareil électronique (1) avec
- une électronique (9) comportant des composants électroniques et/ou électromécaniques disposés dans une chambre électronique (7) et
- un dispositif (15) destiné à la détection et/ou la surveillance d'une usure des composants électroniques et/ou électromécaniques (11),
- qui comporte au minimum un composant (17, 17a, 17b) indépendant de l'électronique, disposé dans la chambre électronique (7),
-- qui présente au minimum une propriété physique, qui se modifie de façon irréversible en fonction de l'usure du composant (17, 17a, 17b),
-- qui présente un circuit (31) destiné à la mesure de cette propriété physique, et
-- qui présente une unité d'exploitation (33),
--- qui, à partir de la propriété physique mesurée, détecte et/ou surveille une usure du composant (17, 17a, 17b), et met à disposition un signal de sortie (S) fonction de l'usure.

2. Appareil électronique (1) selon la revendication 1, pour lequel le composant (17, 17a, 17b) est disposé sur un endroit exposé.

3. Appareil électronique (1) selon la revendication 1, pour lequel le composant (17a) comprend un bloc en plastique (19), qui est entouré au moins partiellement d'un revêtement (21) constitué d'un métal commun.

4. Appareil électronique (1) selon la revendication 1, pour lequel le composant (17b) est un condensateur de structure discrète et la propriété est une capacité du condensateur.

5. Appareil électronique (1) selon la revendication 1, pour lequel le composant est une résistance (17a).
